# EUROPEAN PATENT SPECIFICATION

(11) **EP 4 565 051 B1**
(45) Date of publication and mention of the grant of the patent: **26.08.2026**
(21) Application number: 23213425.4
(22) Date of filing: 30.11.2023
(51) Int. Cl.: H10N 60/01, H10N 60/12

(54) **A JOSEPHSON JUNCTION DEVICE AND METHOD OF PRODUCING THE DEVICE**
JOSEPHSON-ÜBERGANGSEINRICHTUNG UND VERFAHREN ZUR HERSTELLUNG DER EINRICHTUNG
DISPOSITIF À JONCTION JOSEPHSON ET PROCÉDÉ DE FABRICATION DU DISPOSITIF

(43) Date of publication of application: 04.06.2025
(73) Proprietor: IMEC VZW, 3001 Leuven (BE)
(72) Inventor: Herr, Anna, 3001 Leuven (BE); Perez Lozano, Daniel, 3001 Leuven (BE); Piao, Xiaoyu, 3001 Leuven (BE); Tokei, Zsolt, 3000 Leuven (BE)
(74) Representative: Patent Department IMEC

(56) References cited:
- US-A- 4 490 733
- SHINOKI F: "Niobium nitride Josephson tunnel junctions with oxidized amorphous silicon barriers", APPLIED PHYSICS LETTERS, vol. 38, no. 4, 15 February 1981 (1981-02-15), 2 Huntington Quadrangle, Melville, NY 11747, pages 285 - 286, XP093158515, ISSN: 0003-6951, DOI: 10.1063/1.92308
- CELASCHI S: "Partially oxidized amorphous silicon as the tunneling barrier for Josephson devices", JOURNAL OF APPLIED PHYSICS, vol. 60, no. 1, 1 July 1986 (1986-07-01), 2 Huntington Quadrangle, Melville, NY 11747, pages 296 - 303, XP093159164, ISSN: 0021-8979, Retrieved from the Internet <URL:https://pubs.aip.org/aip/jap/article-pdf/60/1/296/18605188/296_1_online.pdf> DOI: 10.1063/1.337644

## Description

### Field of the Invention

The present invention is related to a Josephson junction device applicable in a superconducting digital logic circuit.

### State of the art.

Superconducting digital logic (SDL) is one of the main technologies of interest for overcoming inherent limitations in terms of energy efficiency of CMOS based integrated circuits. An SDL circuit comprises superconducting wires and Josephson junctions. Josephson junctions are known in various forms, but in SDL circuits, the most common implementation takes the form of a dielectric material sandwiched between two superconducting electrodes. In an SDL circuit, the Josephson junction enables changing the magnetic flux in a superconducting loop by an integer number of a single magnetic flux quantum (SFQ).

The material of choice for the electrodes of Josephson junctions applied in SDL circuits has most often been niobium, with Al₂O₃ or amorphous silicon (hereafter abbreviated as α-Si) as the barrier layer. A Nb/α-Si/Nb stack is however not compatible with process steps which require temperatures higher than 150°C-200°C, such as many steps required in back end of line processing, because the Nb intermixes with silicon above this temperature, thereby reducing the thickness of the barrier. This makes it difficult also to scale down Josephson junctions of this type to the micrometre sized dimensions required for high density SDL circuits. Examples of prior art documents are US4490733A and SHINOKI F: "Niobium nitride Josephson tunnel junctions with oxidized amorphous silicon barriers", APPLIED PHYSICS LETTERS, vol. 38, no. 4, 15 February 1981, pages 285-286.

### Summary of the invention

The invention is related to a Josephson junction stack and a device obtainable from said stack and a method for producing said stack and said device in accordance with the appended claims. A Josephson junction stack according to the invention comprises a first superconducting electrode layer, a barrier layer directly on the first superconducting electrode layer and a second superconducting electrode layer directly on the barrier layer. The superconducting electrode layers are formed of a superconducting nitride material, and the barrier layer consists of a stack of an amorphous Si layer and directly on said amorphous Si layer : a passivation layer formed of a mixture of Si with a second element. The mixed layer is a passivation layer in the sense that it prevents the formation of silicon nitride during or after the formation of the second electrode layer, i.e. it prevents N from the second electrode layer material from reacting with Si from the amorphous Si layer. The mixed layer can thus be said to passivate the α-Si layer.

The invention is in particular related to a Josephson junction stack comprising a first superconducting electrode layer, a barrier layer directly on the first superconducting electrode layer and a second superconducting electrode layer directly on the barrier layer,
- wherein the superconducting electrode layers are formed of a superconducting nitride material, and
- characterised in that the barrier layer consists of a stack of an amorphous Si layer directly on the first superconducting electrode layer and directly on said amorphous Si layer : a passivation layer formed of a mixture of Si with a second element.

According to an embodiment, the superconducting electrode layers are formed of NbTiN or NbN or TiN.

According to an embodiment, the second element is chosen from the group consisting of Ti, Ta and Co.

The invention is also related to a Josephson junction device including a Josephson junction stack according to the invention.

The invention is also related to a method for producing a Josephson junction stack according to the invention, comprising the steps of :
- providing a support substrate,
- producing the first superconducting electrode layer on the support substrate,
- producing an amorphous Si layer on the first superconducting electrode layer,
- depositing the second element on the amorphous Si layer under conditions which cause intermixing of the second element with a top portion of the amorphous Si layer, so that the original amorphous Si layer is thinned and so that said passivation layer formed of a mixture of Si with the second element is formed on the thinned amorphous Si layer,
- producing the second superconducting electrode layer on the passivation layer formed of said mixture.

According to an embodiment of the method, the first and second superconducting electrode layers are formed of NbTiN and wherein said electrode layers are formed by physical vapour deposition (PVD) at a temperature between 300°C and 450°C.

According to a further embodiment of the method, the second element is Ti, and wherein the layer of Ti is deposited by PVD at a temperature between 300°C and 450°C.

According to a further embodiment of the method, the amorphous Si layer is produced by PVD at a temperature between room temperature and 90°C.

The invention is also related to a method for producing a Josephson junction device integrated in a superconducting digital circuit, comprising the steps of :
- producing a Josephson junction stack according to the method of the invention,
- patterning the stack, to thereby obtain the Josephson junction device, comprising first and second electrodes and a barrier sandwiched between said electrodes,
- producing conductors of the circuit, wherein two of said conductors are respectively connected to the first and second electrodes of the device.

### Brief description of the figures

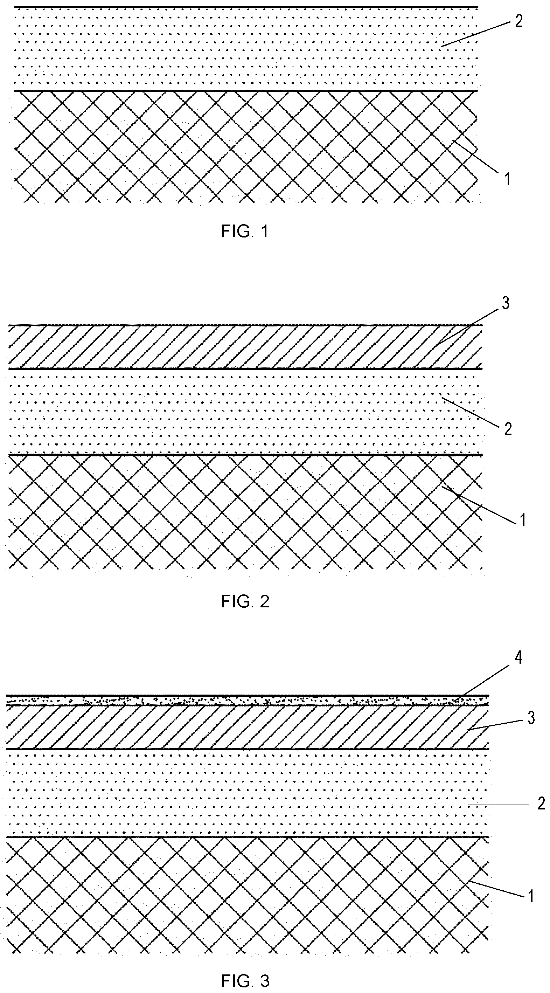

Figures 1 to 5 illustrate the method steps for obtaining a Josephson junction stack in accordance with an embodiment of the invention.

### Detailed description of the invention

A method for producing a Josephson junction stack according to an embodiment of the invention is described with reference to Figures 1 to 5. A Josephson junction stack is defined within the present description as a stack of layers deposited on a substrate and suitable for forming a Josephson junction device by patterning those layers.

Unless it is stated otherwise, the materials cited in the following paragraphs are cited by way of example and these materials therefore do not limit the scope of the invention. All references to dimensions and parameters related to production methods are cited purely by way of example and therefore do not limit the scope of the invention. Alternatives for some of these dimensions, parameters or methods will be mentioned, where appropriate.

Figure 1 illustrates a small portion of a Si substrate 1 with a SiO₂ layer 2 on the upper surface of the substrate. The Si substrate may be a standard Si process wafer of 300 mm in diameter, or it may be the Si top layer of an SOI (silicon-on-insulator) substrate. Besides Si, the method of the invention is however applicable on other substrate types and materials thereof.

The thickness of the SiO₂ layer 2 is about 100 nm. As shown in Figure 2, a layer 3 of superconducting NbTiN of about 50 nm thick is deposited on the SiO₂ layer 2. This may be done by various methods known as such in the art. Layer 3 may for example be produced by Physical Vapour Deposition (PVD) : with the substrate placed in a PVD chamber, Nb and Ti are co-sputtered at 754 W and 500 W, respectively in the presence of an argon flow of 17 standard cubic centimetres per minute (sccm) and a nitrogen flow of 15 sccm, at a temperature of 420 °C during 40 minutes. It is known to the skilled person that other deposition powers and gas flows can be applied during other deposition times, which results in other superconducting varieties of NbTiN, for example in terms of crystallinity or resistivity.

This is followed, as illustrated in Figure 3 by the deposition of a layer 4 of α-Si, which can be done also by PVD, at a temperature of 70°C, during about 20 min, resulting in a α-Si layer 4 having a thickness of about 10 nm. The deposition of α-Si takes place after moving the substrate to another PVD reactor, operated at the lower temperature of 70°C.

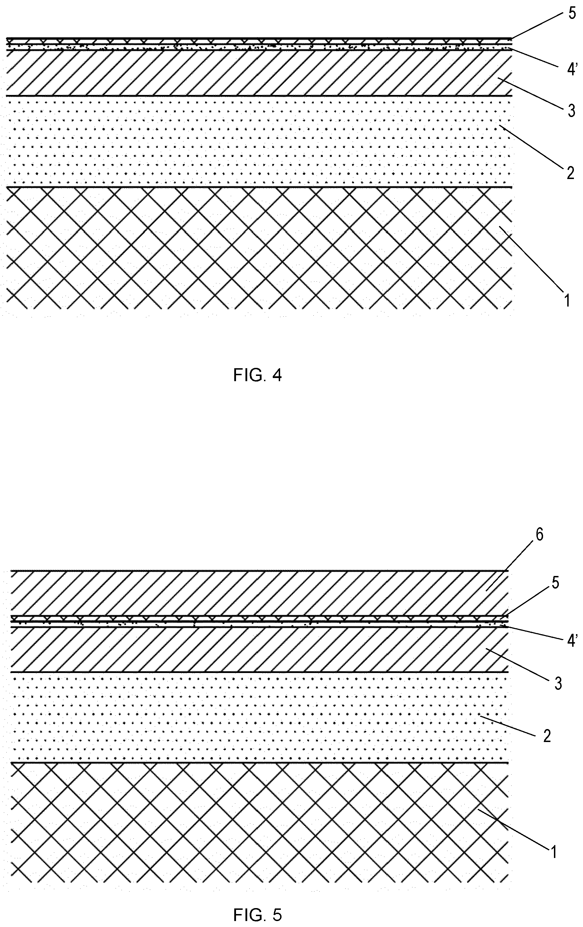

Thereafter, and with reference to Figure 4, Ti is deposited by PVD on the α-Si layer 4, also at 420°C (preferably again in the first chamber), during about 200 s. During this deposition, Ti and Si intermix and form a mixed Ti/Si layer 5 on a thinned α-Si layer 4'. The original α-Si layer 4 is thinned as a consequence of the intermixing of Si from the original α-Si layer 4 with the deposited Ti. The thickness reduction of the original α-Si layer is in the order of 5 nm, leaving an α-Si layer 4' of about 5 nm thick, while the mixed Ti/Si layer 5 has a thickness of about 5 nm. With reference to Figure 5, this is followed by the formation of a top NbTiN layer 6 of about the same thickness as the first NbTiN layer 3, again by co-sputtering Ti and Nb, for example applying the same parameters as applied for layer 3.

The function of the intermixed Ti/Si layer 5 is to act as a passivation layer that passivates the α-Si layer 4', i.e. it prevents the formation of SiN by a bonding reaction between Si from the α-Si layer 4' and N from the second electrode layer 6. Such SiN formation would lead to a much higher resistance of the Josephson junction, and thereby to a reduction of the critical current density of the junction.

The resulting stack is a Josephson junction stack having a bottom electrode layer 3, a top electrode layer 6, an α-Si layer 4' on the bottom electrode layer and an intermixed Ti/Si passivation layer 5 on the α-Si layer, wherein the α-Si layer 4' and the intermixed Si/Ti layer 5 together form the barrier of the Josephson junction defined by the stack.

The use of superconducting NbTiN for the electrode layers 3 and 6 is advantageous compared to Nb because the Nb is bound to Ti and N and therefore cannot diffuse into the Si of layer 4. In addition, NbTiN is compatible with high processing temperatures applicable in BEOL processing, so that a Josephson junction device according to the invention can be integrated in a BEOL structure. The deposition of NbTiN takes place at temperatures which are of the same order as the BEOL processing temperatures (preferably between 300°C and 450°C). For this reason, the material is compatible with said BEOL processing temperatures, i.e. diffusion of Nb is avoided.

Generally, the deposition temperature of Ti for forming the mixed layer 5 is preferably between 300°C and 450°C. As stated, the thicknesses of the layers described above are not limiting the scope of the invention. Thicknesses are applicable which enable the functionality of the various layers, namely for layers 3 and 6 to act as electrodes of a Josephson junction device, for layers 4 and 5' combined to act as barrier layer of said device, and for layer 5' to act as a passivation layer as explained above.

The Josephson junction stack illustrated in the drawings is produced on a SiO₂ layer 2 which isolates the stack from the Si substrate 1. This is required only if the Si substrate is a standard 300 mm Si wafer with low resistivity. When the Si wafer is a high resistivity wafer, the isolation layer 2 may be omitted. The stack can also be produced after first forming multiple other layers on the Si wafer including front end of line layers and back end of line layers as defined by a particular layout of an SDL circuit.

The temperature resistance of a Josephson junction stack according to the invention combines with other advantages. The junction stack is highly scalable, i.e. it can be processed to form very small devices with good electrical properties in terms of the functionality of the devices in an SDL circuit. The critical current density scales exponentially as a function of the barrier thickness. This means that a required critical current is obtainable in a heavily scaled-down device, while still enabling a relatively thick α-Si barrier 4' of for example about 10nm. This is advantageous both for the reproducibility of the junction and for the operation speed : the high barrier thickness leads to a low capacitance, which increases the obtainable speed.

Whereas the invention is limited to the use of amorphous Si in the barrier, other components of the junction are not limited to the above-named materials. The electrode layers 3 and 6 are generally formed of a superconducting material comprising nitrogen. An alternative to NbTiN is for example NbN or TiN.

Other elements instead of Ti may be used for the same function, namely obstructing the formation of SiN by forming a mixed layer formed of said element and Si between the α-Si layer 4' and the second superconducting electrode layer 6. Such elements include for example Ta and Co.

As to the method of the invention for forming the Josephson junction stack, other processes can be used for forming the layers of the stack. For example Atomic Layer Deposition can be used to form the electrode layers 3 and 6, the α-Si layer 4 and the Ti layer 5. Other suitable methods for forming the bottom and top electrode layers 3 and 6 include single target PVD and CVD (chemical vapour deposition).

An actual Josephson junction device according to the invention, integrated in a layer structure of an integrated circuit chip, can be produced by methods applied for the production of currently known chips comprising SDL circuits. This includes producing a Josephson junction stack in accordance with the invention, and patterning the stack so as to obtain the Josephson junction device comprising a patterned portion of the bottom electrode layer 3, the barrier layer 4'+5 and the top electrode layer 6, respectively forming the first electrode, barrier and second electrode of the device. Following this, conductors are produced wherein two of said conductors are respectively connected to the first and second electrode of the device. An example of a Josephson junction device integrated in an SDL chip is disclosed in patent publication document US20230210022. A Josephson junction stack according to the invention, produced by any of the methods described above, can be used to produce the device as disclosed in the cited application and in other known examples of Josephson junction devices applied in an SDL circuit.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A Josephson junction stack comprising a first superconducting electrode layer (3), a barrier layer (4',5) directly on the first superconducting electrode layer (3) and a second superconducting electrode layer (6) directly on the barrier layer,
- wherein the superconducting electrode layers (3,6) are formed of a superconducting nitride material, and
- **characterised in that**
the barrier layer consists of a stack of an amorphous Si layer (4') directly on the first superconducting electrode layer (3) and directly on said amorphous Si layer : a passivation layer (5) formed of a mixture of Si with a second element.

2. The Josephson junction stack according to claim 1, wherein the superconducting electrode layers (3,6) are formed of NbTiN or NbN or TiN,

3. The Josephson junction stack according to claim 1 or 2, wherein the second element is chosen from the group consisting of Ti, Ta and Co.

4. A Josephson junction device including the Josephson junction stack according to any one of the preceding claims.

5. A method for producing a Josephson junction stack according to any one of claims 1 to 3, comprising the steps of :
- providing a support substrate (1,2),
- producing the first superconducting electrode layer (3) on the support substrate,
- producing an amorphous Si layer (4) on the first superconducting electrode layer,
- depositing the second element on the amorphous Si layer under conditions which cause intermixing of the second element with a top portion of the amorphous Si layer, so that the original amorphous Si layer (4) is thinned and so that said passivation layer (5) formed of a mixture of Si with the second element is formed on the thinned amorphous Si layer (4'), and
- producing the second superconducting electrode layer (6) on the passivation layer (5) formed of said mixture.

6. The method according to claim 5, wherein the first and second superconducting electrode layers (3,6) are formed of NbTiN and wherein said electrode layers are formed by physical vapour deposition, PVD, at a temperature between 300°C and 450°C.

7. The method according to claim 5 or 6, wherein the second element is Ti, and wherein the layer of Ti is deposited by PVD at a temperature between 300°C and 450°C.

8. The method according to any one of claims 5 to 7, wherein the amorphous Si layer (4) is produced by PVD at a temperature between room temperature and 90°C.

9. A method for producing a Josephson junction device integrated in a superconducting digital circuit, comprising the steps of :
- producing a Josephson junction stack according to the method of any one of claims 5 to 8,
- patterning the stack, to thereby obtain the Josephson junction device, comprising first and second electrodes and a barrier sandwiched between said electrodes,
- producing conductors of the circuit, wherein two of said conductors are respectively connected to the first and second electrodes of the device.

## Patentansprüche

1. Josephson-Übergangsstapel, umfassend eine erste supraleitende Elektrodenschicht (3), eine Barriereschicht (4',5) direkt auf der ersten supraleitenden Elektrodenschicht (3) und eine zweite supraleitende Elektrodenschicht (6) direkt auf der Barriereschicht,
- wobei die supraleitenden Elektrodenschichten (3, 6) aus einem supraleitenden Nitridmaterial gebildet sind, und
- **dadurch gekennzeichnet, dass**
die Barriereschicht aus einem Stapel einer amorphen Si-Schicht (4') direkt auf der ersten supraleitenden Elektrodenschicht (3) besteht und direkt auf dieser amorphen Si-Schicht: eine Passivierungsschicht (5), die aus einem Gemisch aus Si mit einem zweiten Element gebildet ist.

2. Josephson-Übergangsstapel nach Anspruch 1,
wobei die supraleitenden Elektrodenschichten (3, 6) aus NbTiN oder NbN oder TiN gebildet sind.

3. Josephson-Übergangsstapel nach Anspruch 1 oder 2,
wobei das zweite Element aus der Gruppe bestehend aus Ti, Ta und Co ausgewählt ist.

4. Josephson-Übergangsvorrichtung, die den Josephson-Übergangsstapel nach einem der vorstehenden Ansprüche beinhaltet.

5. Verfahren zur Herstellung eines Josephson-Übergangsstapels nach einem der Ansprüche 1 bis 3, umfassend die Schritte zum:
- Bereitstellen eines Trägersubstrats (1, 2),
- Herstellen der ersten supraleitenden Elektrodenschicht (3) auf dem Trägersubstrat,
- Herstellen einer amorphen Si-Schicht (4) auf der ersten supraleitenden Elektrodenschicht,
- Abscheiden des zweiten Elements auf der amorphen Si-Schicht unter Bedingungen, die Vermischen des zweiten Elements mit einem oberen Abschnitt der amorphen Si-Schicht bewirken, sodass die ursprüngliche amorphe Si-Schicht (4) ausgedünnt wird und sodass die Passivierungsschicht (5), die aus einem Gemisch von Si und dem zweiten Element gebildet wird, auf der ausgedünnten amorphen Si-Schicht (4') gebildet wird, und
- Herstellen der zweiten supraleitenden Elektrodenschicht (6) auf der aus dem Gemisch gebildeten Passivierungsschicht (5).

6. Verfahren nach Anspruch 5, wobei die erste und zweite supraleitende Elektrodenschicht (3, 6) aus NbTiN gebildet sind und wobei die Elektrodenschichten durch physikalische Dampfabscheidung, PVD, bei einer Temperatur zwischen 300°C und 450°C gebildet werden.

7. Verfahren nach Anspruch 5 oder 6, wobei das zweite Element Ti ist und wobei die Ti-Schicht durch PVD bei einer Temperatur zwischen 300°C und 450°C abgeschieden wird.

8. Verfahren nach einem der Ansprüche 5 bis 7, wobei die amorphe Si-Schicht (4) durch PVD bei einer Temperatur zwischen Raumtemperatur und 90°C hergestellt wird.

9. Verfahren zur Herstellung einer in eine supraleitende digitale Schaltung integrierten Josephson-Übergangsvorrichtung, umfassend die Schritte zum:
- Herstellen eines Josephson-Übergangsstapels gemäß dem Verfahren nach einem der Ansprüche 5 bis 8,
- Mustern des Stapels, um dadurch die Josephson-Übergangsvorrichtung zu erhalten, die eine erste und zweite Elektrode und eine zwischen den Elektroden eingebettete Barriere umfasst,
- Herstellen von Leitern der Schaltung, wobei zwei der Leiter jeweils mit der ersten und zweiten Elektrode der Vorrichtung verbunden sind.

## Revendications

1. Empilement de jonction Josephson comprenant une première couche d'électrode supraconductrice (3), une couche barrière (4',5) directement sur la première couche d'électrode supraconductrice (3) et une seconde couche d'électrode supraconductrice (6) directement sur la couche barrière,
- dans lequel les couches d'électrodes supraconductrices (3,6) sont formées d'un matériau en nitrure supraconducteur, et
- **caractérisé en ce que**
la couche barrière est constituée d'un empilement d'une couche de Si amorphe (4') directement sur la première couche d'électrode supraconductrice (3) et directement sur ladite couche de Si amorphe : une couche de passivation (5) formée d'un mélange de Si avec un second élément.

2. Empilement de jonction Josephson selon la revendication 1,
dans lequel les couches d'électrodes supraconductrices (3,6) sont formées de NbTiN ou NbN ou TIN.

3. Empilement de jonction Josephson selon la revendication 1 ou 2,
dans lequel le second élément est choisi dans le groupe constitué de Ti, Ta et Co.

4. Dispositif à jonction Josephson comprenant l'empilement de jonction Josephson selon l'une quelconque des revendications précédentes.

5. Procédé de production d'un empilement de jonction Josephson selon l'une quelconque des revendications 1 à 3, comprenant les étapes de :
- fourniture d'un substrat de support (1,2),
- production de la première couche d'électrode supraconductrice (3) sur le substrat de support,
- production d'une couche de Si amorphe (4) sur la première couche d'électrode supraconductrice,
- dépôt du second élément sur la couche de Si amorphe dans des conditions qui provoquent un mélange du second élément avec une partie supérieure de la couche de Si amorphe de sorte que la couche de Si amorphe originale (4) soit amincie et que ladite couche de passivation (5), formée d'un mélange de Si avec le second élément, soit formée sur la couche de Si amorphe amincie (4'), et
- production de la seconde couche d'électrode supraconductrice (6) sur la couche de passivation (5) formée dudit mélange.

6. Procédé selon la revendication 5, dans lequel les première et seconde couches d'électrodes supraconductrices (3,6) sont formées de NbTiN et dans lequel lesdites couches d'électrodes sont formées par dépôt physique en phase vapeur, PVD, à une température comprise entre 300 °C et 450 °C.

7. Procédé selon la revendication 5 ou 6, dans lequel le second élément est du Ti, et dans lequel la couche de Ti est déposée par PVD à une température comprise entre 300 °C et 450 °C.

8. Procédé selon l'une quelconque des revendications 5 à 7, dans lequel la couche de Si amorphe (4) est produite par PVD à une température comprise entre la température ambiante et 90 °c.

9. Procédé de production d'un dispositif à jonction Josephson intégré dans un circuit numérique supraconducteur, comprenant les étapes de:
- production d'un empilement de jonction Josephson selon le procédé selon l'une quelconque des revendications 5 à 8,
- structuration de l'empilement afin d'obtenir ainsi le dispositif à jonction Josephson, comprenant une première et une seconde électrode et une barrière prise en sandwich entre lesdites électrodes,
- production de conducteurs du circuit, dans lequel deux desdits conducteurs sont respectivement connectés aux première et seconde électrodes du dispositif.
